# EUROPÄISCHE PATENTANMELDUNG

(11) **EP 1 962 351 A1**
(43) Veröffentlichungstag der Anmeldung: **27.08.2008**
(21) Anmeldenummer: 08100466.5
(22) Anmeldetag: 15.01.2008
(51) Int. Cl.: H01L 41/053, F02M 51/00, F02M 51/06

(54) **Piezoaktormodul mit einer Kabeldurchführung**

(30) Priorität: 22.02.2007 DE 102007008618
(71) Anmelder: ROBERT BOSCH GMBH, 70442 Stuttgart (DE)
(72) Erfinder: Uhlmann, Dietmar, 71404, Korb (DE); Ferraro, Giovanni, 71642, Ludwigsburg (DE)

(57) **Zusammenfassung**

Es wird ein Piezoaktormodul mit einem einen Innenraum aufweisenden Haltekörper (2,3) und einem in dem Innenraum angeordneten Piezoaktor (11) vorgeschlagen, der über elektrische Zuleitungen (31,32) am Aktorfuß (28) kontaktierbar ist, wobei der Piezoaktor über seinen Aktorkopf (22) an einem über den durch den Piezoaktor verursachten Aktorhub zu steuernden mechanischen Stellglied im Haltekörper (2,3) anliegt. Der Haltekörper (2,3) und die mechanischen und/oder elektrischen Kontakte des Piezoaktormoduls sind so ausgebildet, dass elektrische und/oder mechanische Schnittstellen am Piezoaktormodul zur Bildung einer austauschbaren Piezoaktorpatrone (21) ausgeführt sind.

## Beschreibung

### Stand der Technik

Die Erfindung betrifft ein Piezoaktormodul mit einer Kabeldurchführung für die elektrische Kontaktierung eines Piezoaktors, gemäß der Gattung des Hauptanspruchs.

Ein solches Piezoaktormodul kann beispielsweise in einem Piezoinjektor zur zeitpunkt- und mengengenauen Dosierung von Kraftstoff für einen Verbrennungsmotor eingesetzt werden und besteht im Wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben oder geschlossen wird.

Aus der DE 101 39 871 A1 ist ein solcher Piezoinjektor mit einem über einen hydraulischen Druckübersetzer auf ein Ventilglied einwirkenden Piezoaktormodul bekannt, bei dem die Piezoelemente des Piezoaktors in einer Hülsen-Membran-Kombination angeordnet sind. An einem Ende befindet sich ein Stahlbauteil (Aktorfuß), durch das über isolierte Zuleitungen die elektrische Kontaktierung der Piezoelemente des Piezoaktors ermöglicht wird.

Eine hier notwendige hochdruckdichte Einbettung der Zuleitungen in das Piezoaktormodul, insbesondere in den Aktorfuß, ist beispielsweise in der DE 10 2004 004 706 A1 beschrieben. Hier wird unter anderem eine dichte Einbettung der Kabel der Zuleitung mittels einer Glaseinschmelzung vorgeschlagen. Außerdem weist dieses bekannte Piezoaktormodul eine feste Ummantelung bzw. Beschichtung mindestens der elektrisch zu isolierenden Seitenflächen des Piezoaktors auf, die eine einfache Austauschbarkeit des Piezoaktormoduls außerordentlich erschwert.

Bisher war es damit üblich, dass das Piezoaktormodul während der Montage, beispielweise des Piezoinjektors, fest im Haltekörper fixiert wurde. Somit können bei einem Piezoinjektor nur das Düsenmodul, die Drossel- und Ventilplatte mit Schaltventil oder das mechanische Kopplermodul ausgetauscht werden. Ist dagegen der Tausch des Piezoaktormoduls erforderlich, so muss bei der bekannten Anordnung zunächst die Steckerumspritzung für die Kontaktierung der Piezoelemente komplett entfernt werden. Nachfolgend kann dann das Piezoaktormodul samt Kabel für die elektrischen Zuleitungen entnommen werden und erst denn kann dann das neue Piezoaktormodul eingesetzt werden und die Positionierung der Kabel erfolgen, sodass der Haltekörper dann neu umspritzt werden kann. Es entsteht bei einem solchen Vorgehen also ein erheblicher Aufwand.

### Offenbarung der Erfindung

Die Erfindung geht von einem Piezoaktormodul in einem einen Innenraum aufweisenden Haltekörper und einem in dem Innenraum angeordneten Piezoaktor aus, der über elektrische Zuleitungen am Aktorfuß und Außenelektroden kontaktierbare Piezoelemente aufweist, wobei das Piezoaktormodul über seinen Aktorkopf an einem über den durch die Piezoelemente verursachten Aktorhub zu steuernden mechanischen Stellglied im Haltekörper anliegt. Erfindungsgemäß sind der Haltekörper und die mechanischen und/oder elektrischen Kontakte des Piezoaktors in vorteilhafter Weise so ausgeführt, dass elektrische und/oder mechanische Schnittstellen am Piezoaktormoduls zur Bildung einer austauschbaren Piezoaktorpatrone ausgeführt sind.

Insbesondere bei einer Verwendung des erfindungemäßen Piezoaktormoduls als Bestandteil eines Piezoinjektors für ein Einspritzsystem für Kraftstoff bei einem Verbrennungsmotor kann durch eine vorgeschlagene zusätzliche elektrische Steckerkontaktierung im Haltekörper und somit durch Schaffung einer elektrischmechanischen Schnittstelle ein einfacher Austausch dieser Piezoaktorpatrone erfolgen.

Die elektrische Schnittstelle im Bereich des Aktorfußes ist dabei durch ein erstes Steckerteil am Aktorfuß mit elektrischen Kontaktstellen und ein zweites Steckerteil im anzufügenden Haltekörper mit zu den Kontaktstellen des ersten Steckerteils korrespondierenden Kontaktstellen ausgebildet. Besonders vorteilhaft kann dabei ein erstes am Aktorfuß befestigtes Steckerteil mit stift- oder hülsenförmigen Kontaktstellen (Steckkontakte) und ein zweites im anzufügenden Haltekörper befestigtes Steckerteil mit zu den Kontaktstellen des ersten Steckerteils jeweils korrespondierenden stift- oder hülsenförmigen Kontaktstellen (Steckkontakte) versehen werden.

Gemäß einer ersten Ausführungsform wird in vorteilhafter Weise die Verbindung an einer Zuleitung durch einen zentralen Steckerpin in einem Steckerteil und einer diesen Steckerpin aufnehmenden Hülse im jeweils anderen Steckerteil und die Verbindung der anderen Zuleitung durch ringförmig um den zentralen Steckerpin herumlaufend ineinanderschiebbare Hülsen gebildet. Dies ist so ausführbar, dass der zentrale Steckerpin und die innere ringförmige Hülse am Steckerteil entweder des Aktorfußes oder des Haltekörpers liegen.

Nach einer anderen Ausführungsform wird in ebenfalls vorteilhafter Weise die Verbindung beider Zuleitungen durch ringförmig um einen isolierenden Dom an einem Steckerteil liegenden Hülsen hergestellt, die während der Montage in jeweils korrespondierende Hülsen in einer entsprechenden Ausnehmung am anderen Steckerteil schiebbar sind, wobei die jeweils vorn am Dom liegenden Hülsen einen gegenüber der anderen Verbindung geringeren Durchmesser aufweisen um ein einfaches Einschieben der Steckerteile zu ermöglichen. Auch bei dieser Ausführungsform liegt der isolierende Dom entweder am Steckerteil des Aktorfußes oder am Steckerteil des Haltekörpers.

Weiterhin wird die leicht einschiebbare und damit leicht austauschbare Piezoaktorpatrone dadurch in vorteilhafter Weise weitergebildet, dass die mechanische Schnittstelle der Piezoaktorpatrone im Bereich des Aktorkopfes durch eine stiftförmige Zuspitzung des Aktorkopfes gebildet ist, die beim Einschieben in eine Aktorraumbohrung in ein Einstellstück des Haltekörpers einfügbar ist.

Um eine sichere Abdichtung der beiden Steckerteile am Aktorfuß nach der Montage zu erreichen, sind im Bereich der mechanischen Verbindung, also abseits der elektrischen Kontaktstellen der beiden Steckerteile, Dichtringe ib Bereich der Steckerteile in einer entsprechenden Ausnehmung eingefügt, die beim Ineinanderfügen der Steckerteile dichtend am jeweils anderen Steckerteil anliegt. Auch hier kann der Dichtring, vorzugsweise ein O-Ring, entweder im Steckerteil des Aktorfußes oder des Haltekörpers liegen.

Mit der Erfindung kann beispielsweise für den Fall, dass eine Fehlfunktion eines Piezoinjektors aufgrund eines nicht einwandfrei funktionierenden Piezoaktormoduls nach der Fertigung bei der Endprüfung detektiert wird, durch eine zusätzliche elektrische Kontaktierung beim Prüfprozess bzw. beim Durchlaufen der Regelschleife, auch der Tausch des Piezoaktormoduls einfach vorgenommen werden. Der Tausch des Piezoaktormoduls kann damit auch auf einfache Weise zum Beispiel auch beim Erreichen der kumulierten maximalen Schaltspielzahl des Piezoaktormoduls vorgesehen werden.

Ein weiterer Vorteil der zusätzlichen Schnittstelle an den beiden Enden des Piezoaktormoduls bzw. der Piezoaktorpatrone ist, dass sehr einfach Untersuchungen einer Vielzahl unterschiedlicher Piezoaktoren und Piezoaktormodulen bereits in einer frühen Bemusterungsphase zur Festlegung beispielsweise eines Piezoinjektor-Zieldesigns hinsichtlich Funktionalität, Zuverlässigkeit und Kosten erfolgen können. Die erfindungsgemäße Piezoaktorpatrone kann neben der vorgeschlagenen Anwendung in einem Piezoinjektor grundsätzlich auch bei weiteren Piezo-Anwendungen, zum Beispiel bei Schaltventilen, eingesetzt werden.

### Kurze Beschreibung der Zeichnungen

Die Erfindung wird nachfolgend anhand der in den Zeichnungen gezeigten Ausführungsbeispiele erläutert. Dabei zeigen:
Figur 1 eine schematische Darstellung eines Piezoinjektors mit einem Piezoaktormodul nach dem Stand der Technik mit Kabeldurchführungen im Längsschnitt,
Figur 2 eine separate Darstellung eines Aktorkopfes mit einer mechanischen Schnittstelle zum Einfügen einer erfindungsgemäßen Piezoaktorpatrone,
Figur 3 ein erstes erfindungsgemäßes Ausführungsbeispiel der elektrischen Schnittstelle am Aktorfuß der Piezoaktorpatrone als Piezoaktormodul mit einem zentralen Steckerpin am Aktorfuß,
Figur 4 ein Detailbild des Steckerteils nach der Figur 3 am Haltekörper des Piezoinjektors,
Figur 5 ein Detailbild des Steckerteils nach der Figur 3 am Aktorfuß des Piezoaktormoduls bzw. der Piezoaktorpatrone,
Figur 6 ein zweites erfindungsgemäßes Ausführungsbeispiel der elektrischen Schnittstelle am Aktorfuß der Piezoaktorpatrone als Piezoaktormodul mit einem zentralen Steckerpin am Haltekörper,
Figur 7 ein Detailbild des Steckerteils nach der Figur 6 am Haltekörper des Piezoinjektors,
Figur 8 ein Detailbild des Steckerteils nach der Figur 6 am Aktorfuß des Piezoaktormoduls bzw. der Piezoaktorpatrone,
Figur 9 ein drittes erfindungsgemäßes Ausführungsbeispiel der elektrischen Schnittstelle am Aktorfuß der Piezoaktorpatrone als Piezoaktormodul mit einem zentralen Dom am Aktorfuß und Hülsen zur Kontaktierung,
Figur 10 ein Detailbild des Steckerteils nach der Figur 9 am Haltekörper des Piezoinjektors,
Figur 11 ein Detailbild des Steckerteils nach der Figur 9 am Aktorfuß des Piezoaktormoduls bzw. der Piezoaktorpatrone,
Figur 12 ein viertes erfindungsgemäßes Ausführungsbeispiel der elektrischen Schnittstelle am Aktorfuß der Piezoaktorpatrone als Piezoaktormodul mit einem zentralen Dom am Haltekörper und Hülsen zur Kontaktierung,
Figur 13 ein Detailbild des Steckerteils nach der Figur 12 am Haltekörper des Piezoinjektors und
Figur 14 ein Detailbild des Steckerteils nach der Figur 12 am Aktorfuß des Piezoaktormoduls bzw. der Piezoaktorpatrone,

### Ausführungsformen der Erfindung

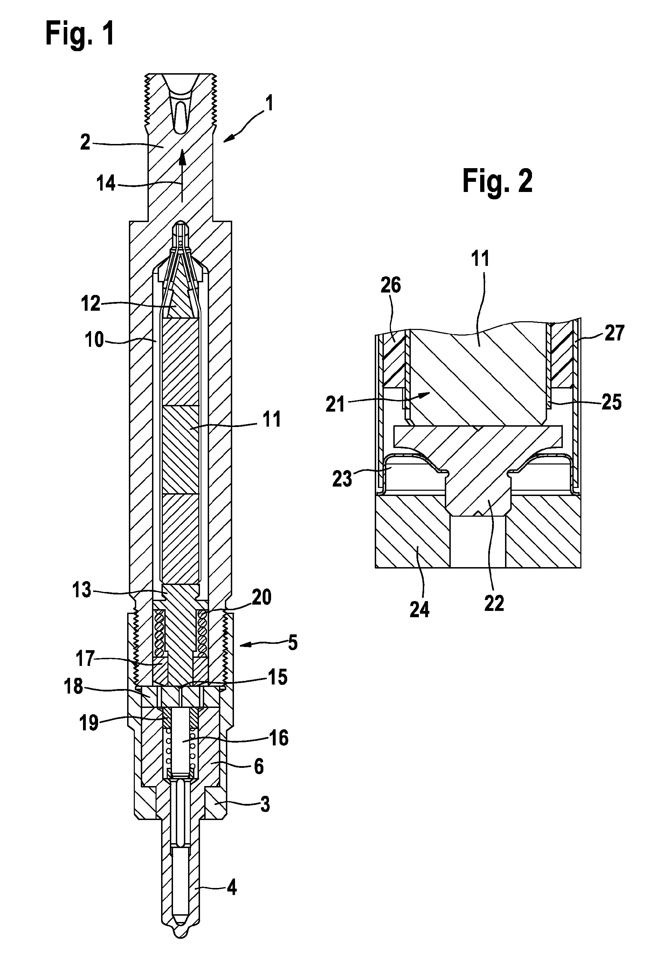

Figur 1 zeigt in einer axialen Schnittdarstellung einen Piezoinjektor 1 als Brennstoffeinspritzventil nach dem in der Beschreibungseinleitung erwähnten Stand der Technik DE 10 2004 004 706 A1 zum direkten Einspritzen von Brennstoff, insbesondere von Dieselkraftstoff, in einen Brennraum eines Verbrennungsmotors.

Der Piezoinjektor 1 weist einen Haltekörper mit einem ersten Gehäuseteil 2, einem zweiten Gehäuseteil 3 und einem dritten Gehäuseteil 4 auf. Dabei ist das dritte Gehäuseteil 4 mittelbar mit dem ersten Gehäuseteil 2 durch das zweite Gehäuseteil 3 verbunden, indem das dritte Gehäuseteil 4 mittels eines Gewindes 5 auf das erste Gehäuseteil 2 aufgeschraubt ist, wobei sich das dritte Gehäuseteil 4 an einem Absatz 6 an dem zweiten Gehäuseteil 3 abstützt.

Das erste Gehäuseteil 2 weist einen durch eine Aussparung gebildeten Innenraum 10 auf, in dem ein aus Piezoelementen gebildeter Piezoaktor 11 vorgesehen ist. Der Piezoaktor 11 stützt sich dabei einerseits über einen Aktorfuß 12 an dem ersten Gehäuseteil 2 ab. Der Aktorfuß 12 ist aus gehärtetem Stahl, vorzugsweise aus einem gehärteten legierten Stahl hergestellt. Auf der anderen Seite stützt sich der Piezoaktor 11 an einem Aktorkopf 13 ab. Der Aktor 11, der Aktorfuß 12 und der Aktorkopf 13 bilden zusammen ein Piezoaktormodul.

Im Innenraum 10 des Piezoinjektors 1 befindet sich beim Betrieb des Piezoinjektors 1 ein Brennstoff unter hohem Druck von 1600 bis 2000 bar oder mehr. Aufgrund des Druckes des Brennstoffs im Innenraum 10 wirkt auf den Aktorfuß 12 eine Kraft in einer Richtung 14, die den Aktorfuß 12 gegen das erste Gehäuseteil 2 presst. Auf diese Weise wird zwischen dem ersten Gehäuseteil 2 und dem Aktorfuß 12 des Piezoaktormoduls eine Hochdruckabdichtung ausgebildet, die ohne weitere Dichtmittel auskommt. Bei einer Betätigung des Piezoaktors 11 erfolgt mittels des Aktorkopfes 13 eine Beeinflussung des Druckes in einem Steuerraum 15, sodass eine Düsennadel 16 geöffnet oder geschlossen wird.

Der Aktorkopf 13 des Aktormoduls bildet gemeinsam mit einer Kopplerhülse 17, einer Distanzplatte 18, einer Steuerraumhülse 19 und der Düsennadel 16 einen hydraulischen Koppler, der sowohl unterschiedliche Wärmeausdehnungen der einzelnen Bauteile ausgleichen kann als auch eine Übersetzung des Hubes des Piezoaktors 11 in den Hub der Düsennadel 18 ermöglicht.

Damit das aus dem Piezoaktor 11, dem Aktorfuß 12 und dem Aktorkopf 13 bestehende Aktormodul die Düsennadel 16 öffnen kann, ist bei der Ansteuerung des Piezoaktors 11 in dem Steuerraum 15 eine negative Druckdifferenz zum umgebenden Innenraum 10 des Piezoinjektors 1 erforderlich. Um zu verhindern, dass der Aktorfuß 12 des Aktormoduls bei der Betätigung des Piezoaktors 11 sich entgegen der Richtung 14 vom ersten Gehäuseteil 2 abhebt, wodurch die Hochdruckabdichtung zwischen dem Aktorfuß 12 und dem ersten Gehäuseteil 2 geöffnet wurde, ist eine Feder 20 vorgesehen, die zusammen mt dem hohen Innendruck im Innenraum 10 die Hochdruckabdichtung zwischen dem Aktorfuß 12 und dem ersten Gehäuseteil 2 aufrechterhält. Somit weist dieser aus der DE 10 2004 004 706 A1 bekannte Piezoaktor 11 eine feste Ummantelung bzw. Beschichtung mindestens der elektrisch zu isolierenden Seitenflächen des Piezoaktors 11 auf, die eine einfache Austauschbarkeit außerordentlich erschwert.

Aus Figur 2 ist eine erste Darstellung einer erfindungsgemäßen mechanischen Schnittstelle zur Bildung einer austauschbaren Piezoaktorpatrone 21 zu entnehmen, die sich in der nachfolgend erläuterten Weise von der in der Figur 1 dargestellten Anordnung nach dem Stand der Technik unterscheidet. Es ist hier zunächst ein Aktorkopf 22 erkennbar, der über eine Zentrierung durch eine Membran 23 und ein Einstellstück 24 einfügbar ist. Das als austauschbare Piezoaktorpatrone 21 ausgeführte Piezoaktormodul weist darüber hinaus noch den eigentlichen Piezoaktor (im Prinzip vergleichbar mit dem Piezoaktor 11 nach der Figur 1) Siebaußenelektroden 25 zur Kontaktierung der Piezoelemente im Piezoaktor 11 und eine Vergussmasse 26 auf, über die die Anordnung in einer Hülse 27 gehalten ist.

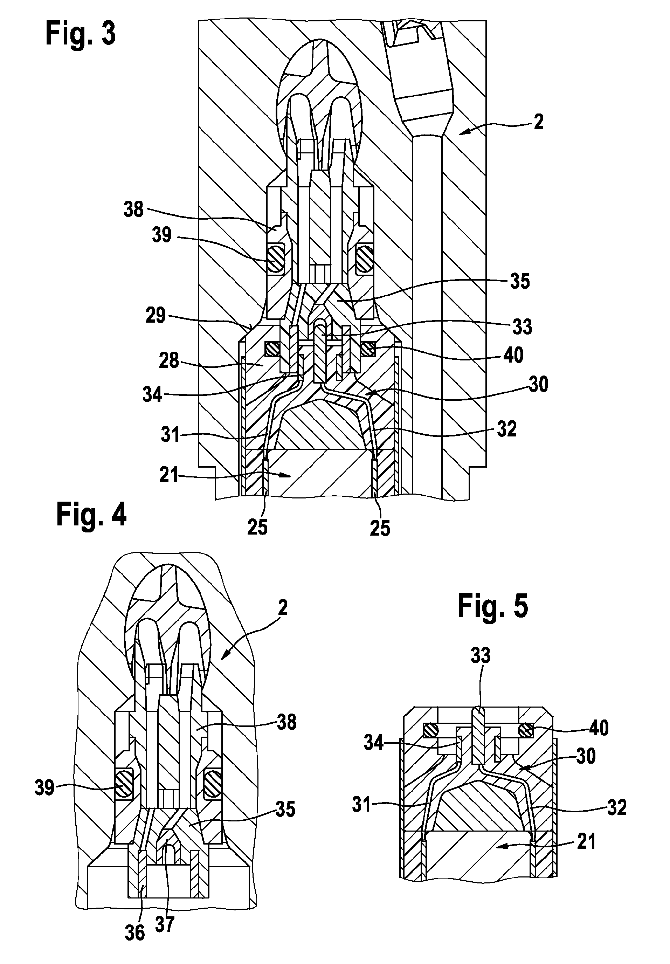

Figur 3 zeigt in Verbindung mit den Detaildarstellungen nach Figur 4 und Figur 5 ein erstes Ausführungsbeispiel einer elektrischen Schnittstelle für die Piezoaktorpatrone 21 mit einem Aktorfuß 28, der über eine Schulter 29 am ersten Gehäuseteil 2 des Haltekörpers für einen erfindungsgemäßen Piezoinjektor anliegt. Eine Vorspannkraft, mit der eine Feder (vgl. die Feder 20 des Kopplermoduls nach der Figur 1) gegen die Piezoaktorpatrone 21 drückt, wird somit an der Schulter 29 des am Gehäuseteil 2 anliegenden Aktorfußes 28 aufgenommen. Die nachfolgend beschriebene elektrische Schnittstelle sieht somit diese axiale Vorspannkraft nicht und ist somit in Axialrichtung lastfrei (entkoppelt). Bei der Montage wird dabei die Piezoaktorpatrone 21 mit der Stirnfläche des Aktorfußes 28 in die Aktorraumbohrung des Haltekörpers bzw. des ersten Gehäuseteils 2 eingeführt.

Im Aktorfuß 28 ist ein Steckerteil 30, beispielsweise aus einem Kunststoff, vorhanden, in das Zuleitungen 31 und 32 für die Kontaktierung der Siebaußenelektroden 25 geführt sind. Für eine Weiterführung der elektrischen Verbindungen der Zuleitungen 31 und 32 nach außen sind Steckkontakte 33 und 34 als Kontaktstellen vorhanden, die anhand der Figuren 4 und 5 näher erläutert werden.

In der Figur 4 ist ebenso wie in der Gesamtdarstellung nach der Figur 3 ein zum Steckerteil 30 nach der Figur 3 für eine Steckverbindung korespondierend aufgebautes Steckerteil 35 im ersten Gehäuseteil 2 des Haltekörpers vorhanden, das zu den Steckkontakten 33 und 34 korrespondierende Steckkontakte 36 (korrespondierend zu Steckkontakt 34) und 37 (korrespondierend zu Steckkontakt 33) aufweist. Beim Einstecken der Piezoaktorpatrone 21 in das erste Gehäuseteil 2 wird somit der stiftförmige zentrale Steckkontakt 33 nach der Figur 5 in den hutförmigen Steckkontakt 37 nach der Figur 4 geführt. Der ringförmige Steckkontakt 36 nach der Figur 4 umschließt dann beim Zusammenfügen der Steckerteile 30 und 35 den inneren hülsenförmigen Steckkontakt 34 nach der Figur 5, sodass beide Pole des Piezoaktors 11 mit einer elektrischen Spannung versorgt werden können.

Die Steckerteile 30 und 35 sind jeweils in Metallteilen angeordnet (Steckerteil 30 im metallischen Aktorfuß 28) wobei hier im Metallteil 38 im ersten Gehäuseteil 2 nach der Figur 4 ein O-Ring 39 zur Abdichtung der Piezoaktorpatrone 21 im Haltekörper und ein O-Ring 40 zur Abdichtung der Steckerteile 30 und 35 im Aktorfuß 28 nach der Figur 3 angeordnet ist.

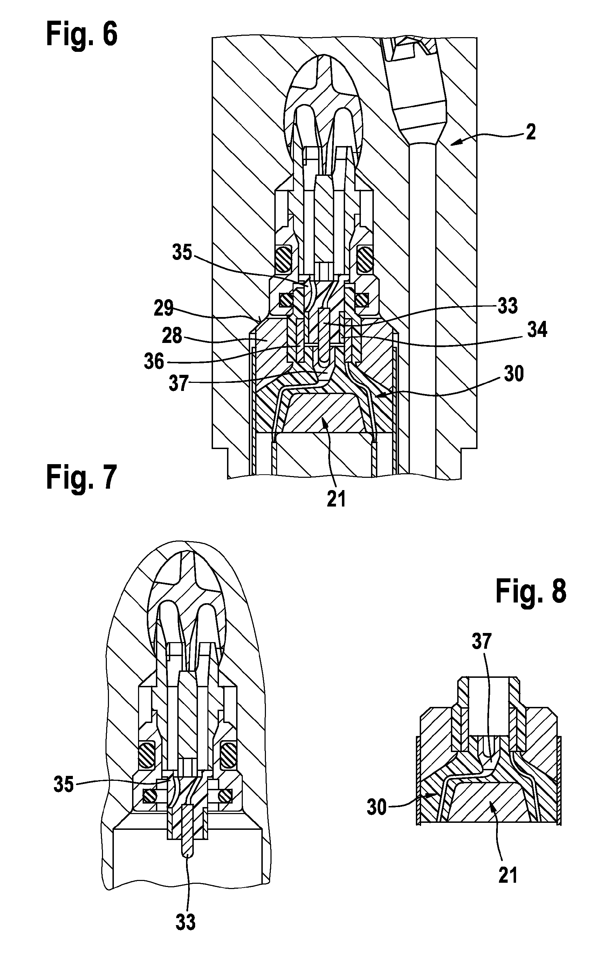

Figur 6 zeigt in Verbindung mit den Detaildarstellungen nach Figur 7 und Figur 8 ein zweites Ausführungsbeispiel einer elektrischen Schnittstelle für die Piezoaktorpatrone 21 mit ebenfalls einem Aktorfuß 28, der über eine Schulter 29 am ersten Gehäuseteil 2 des Haltekörpers für den Piezoinjektor anliegt. Es werden hier nur die Abwandlungen gegenüber der Ausführung nach den Figuren 3 bis 5 beschrieben, wobei im wesentlichen hier nur eine Verlagerung des Stiftes des Steckkontaktes 33 in das obere Steckerteil 35 und eine Verlagerung des hutförmigen Steckkontaktes 37 in das untere Steckerteil 30 vorgenommen wurde. Entsprechen wurden auch die Steckkontakte 34 und 36 verlagert.

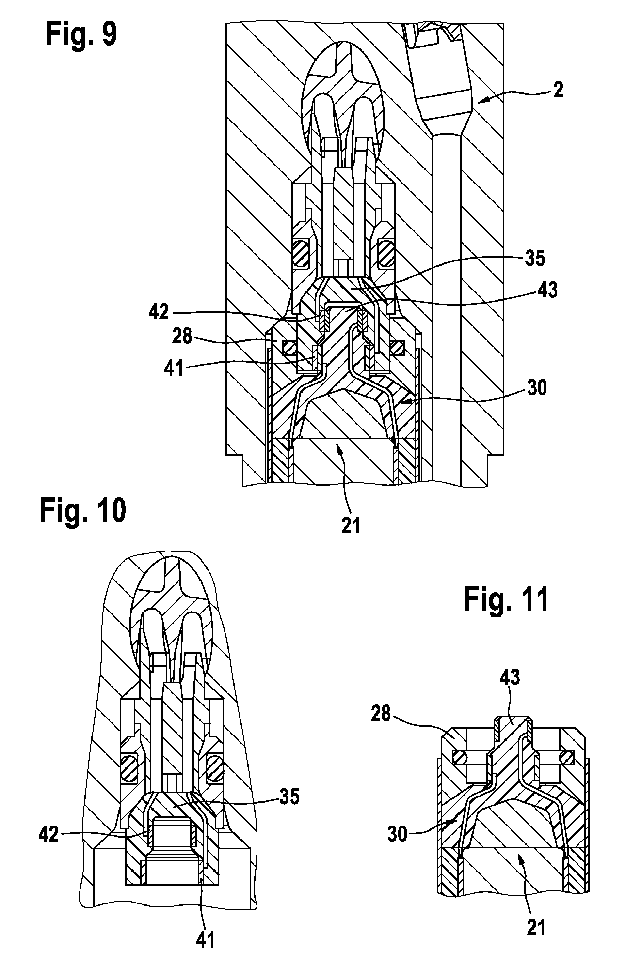

Figur 9 zeigt in Verbindung mit den Detaildarstellungen nach Figur 10 und Figur 11 ein drittes Ausführungsbeispiel einer elektrischen Schnittstelle für die Piezoaktorpatrone 21, bei dem für beide Pole der Zuleitungen hülsenförmige Steckkontaktanordnungen 41 und 42 vorgesehen sind, wobei hier die inneren Steckkontakte auf einem Dom 43 im Steckerteil 30 am Aktorfuß 28 angeordnet sind. Hierbei sind im wesentlichen nur die abweichenden und die für das Verständnis notwendigen Bauelemente mit einem Bezugszeichen versehen, wobei bei den mit den vorherigen Figuren übereinstimmend bezeichneten Bauelementen auf die vorhergehenden Erläuterungen verwiesen wird.

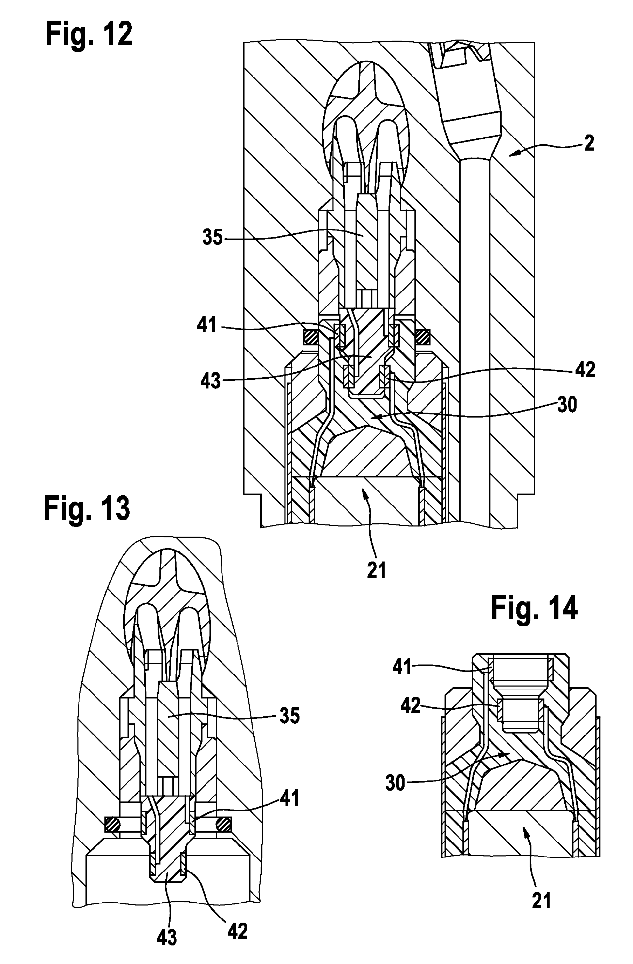

Figur 12 zeigt in Verbindung mit den Detaildarstellungen nach Figur 13 und Figur 14 eine Abwandlung des dritten Ausführungsbeispiels einer elektrischen Schnittstelle für die Piezoaktorpatrone 21, bei dem der Dom 43 im Steckerteil 35 im Haltekörper angeordnet ist, ansonsten aber der Anordnung nach den Figuren 9 bis 11 entspricht.

## Patentansprüche

1. Piezoaktormodul mit einem einen Innenraum aufweisenden Haltekörper (2,3,4) und einem in dem Innenraum über elektrische Zuleitungen (31,32) am Aktorfuß (28) kontaktierbaren Piezoaktor (11), wobei der Piezoaktor über einen Aktorkopf (22) an einem über den durch den Piezoaktor (11) verursachten Aktorhub zu steuernden mechanischen Stellglied im Haltekörper (2,3,4) anliegt, **dadurch gekennzeichnet, dass** der Haltekörper und die mechanischen und/oder elektrischen Kontakte des Piezoaktormoduls so ausgeführt sind, dass elektrische und/oder mechanische Schnittstellen am Piezoaktormodul zur Bildung einer austauschbaren Piezoaktorpatrone (21) ausgeführt sind.

2. Piezoaktormodul nach Anspruch 1, **dadurch gekennzeichnet, dass** die elektrische Schnittstelle im Bereich des Aktorfußes (28) durch ein erstes Steckerteil (30) am Aktorfuß (28) mit elektrischen Steckkontakten (33,34,36,37;41,42) und ein zweites Steckerteil (35) im Haltekörper mit zu den Kontaktstellen des ersten Steckerteils (30) korrespondierenden Steckkontakten (33,34,36,37;41,42) ausgebildet ist.

3. Piezoaktormodul nach Anspruch 2, **dadurch gekennzeichnet, dass** die elektrische Schnittstelle im Bereich des Aktorfußes (28) durch ein erstes am Aktorfuß (28) befestigtes Steckerteil (30) mit stift- oder hülsenförmigen Steckkontakten (33,34,36,37;41,42) und ein zweites im Haltekörper befestigtes Steckerteil (35) mit zu den Steckkontakten (33,34,36,37;41,42) des ersten Steckerteils (30) jeweils korrespondierenden stift- oder hülsenförmigen Steckkontakten (33,34,36,37;41,42) ausgebildet ist.

4. Piezoaktormodul nach Anspruch 3, **dadurch gekennzeichnet, dass** eine Verbindung einer Zuleitung (31,32) durch einen zentralen Steckerpin in einem Steckerteil (30,35) als Steckkontakt und einer diesen Steckerpin aufnehmenden hutförmigen Hülse als Steckkontakt im jeweils anderen Steckerteil (30,35) und die Verbindung der anderen Zuleitung (31,32) durch ringförmig um den zentralen Steckerpin herumlaufend ineinanderschiebbare Hülsen gebildet ist.

5. Piezoaktormodul nach Anspruch 4, **dadurch gekennzeichnet, dass** der zentrale Steckerpin als Steckkontakt (33,37) und die innere ringförmige Hülse als Steckkontakt (34,36) am Steckerteil (30) des Aktorfußes (28) liegen.

6. Piezoaktormodul nach Anspruch 4, **dadurch gekennzeichnet, dass** der zentrale Steckerpin als Steckkontakt (33,37) und die innere ringförmige Hülse als Steckkontakt (34,36) am Steckerteil (35) des Haltekörpers liegen.

7. Piezoaktormodul nach Anspruch 3, **dadurch gekennzeichnet, dass** die Verbindung beider Zuleitungen (31,32) durch ringförmig um einen isolierenden Dom (43) an einem Steckerteil (30,35) liegenden Hülsen als Steckkontaktanordnung (41,42), deren Steckkontakte während der Montage in jeweils korrespondierende Hülsen als Steckkontakte (41,42) in einer entsprechenden Ausnehmung am anderen Steckerteil (30,35) schiebbar sind, wobei die jeweils vorn am Dom (43) liegenden Hülsen als Steckkontaktanordnung (42) einen gegenüber der anderen Verbindung geringeren Durchmesser aufweisen.

8. Piezoaktormodul nach Anspruch 7, **dadurch gekennzeichnet, dass** der isolierende Dom (43) am Steckerteil (30) des Aktorfußes (28) liegt.

9. Piezoaktormodul nach Anspruch 7, **dadurch gekennzeichnet, dass** der isolierende Dom (43) am Steckerteil (35) des Haltekörpers liegt.

10. Piezoaktormodul nach einem der vorhergehenden Ansprüche, **dadurch gekennzeichnet, dass** die mechanische Schnittstelle der Piezoaktorpatrone (21) im Bereich des Aktorkopfes (22) durch eine stiftförmige Zuspitzung des Aktorkopfes (22) gebildet ist, die in eine Aktorraumbohrung in einem Einstellstück (24) des Haltekörpers einfügbar ist.

11. Piezoaktormodul nach einem der vorhergehenden Ansprüche, **dadurch gekennzeichnet, dass** im Bereich der mechanischen Verbindung der Steckerteile (30,35) mindestens ein Dichtring (39,40) eingefügt ist, die beim Ineinanderfügen der Steckerteile dichtend am jeweils gegenüberliegenden Bauteil anliegen.

12. Verwendung eines Piezoaktormoduls nach einem der vorhergehenden Ansprüche, **dadurch gekennzeichnet, dass** das als Piezoaktorpatrone (21) ausgeführte Piezoaktormodul Bestandteil eines Piezoinjektors für ein Einspritzsystem für Kraftstoff bei einem Verbrennungsmotor ist.
